# EUROPEAN PATENT APPLICATION

(11) **EP 4 645 029 A1**
(43) Date of publication of application: **05.11.2025**
(21) Application number: 23911424.2
(22) Date of filing: 15.11.2023
(51) Int. Cl.: G06F 1/16, H05K 5/02

(54) **ELECTRONIC APPARATUS**

(30) Priority: 28.12.2022 JP 2022211873
(71) Applicant: Panasonic Intellectual Property Management Co., Ltd., Kadoma-shi, Osaka 571-0057 (JP)
(72) Inventor: FURUJIKU Masaru, Kadoma-shi, Osaka 571-0057 (JP); KITAHARA Takuya, Kadoma-shi, Osaka 571-0057 (JP)
(74) Representative: Grünecker Patent- und Rechtsanwälte PartG mbB
(86) International application number: PCT/JP2023/041048
(87) International publication number: WO 2024/142642

(57) **Abstract**

An electronic apparatus includes an apparatus body, a handle, a first attachment member, and a second attachment member. The apparatus body includes a first surface including a display and a second surface that intersects with the first surface and extends in the first direction. The handle is attached to the second surface to be rotatable about the rotation axis. The first attachment member is positioned at one end of the second surface of the apparatus body in the first direction, and one end portion of the handle in the first direction is rotatably attached around the rotation axis. The second attachment member is positioned at the other end of the second surface of the apparatus body in the first direction, and the other end portion of the handle in the first direction is rotatably attached around the rotation axis. The first attachment member has a first lock portion that is connectable to the first carry strap, and the second attachment member has a second lock portion that is connectable to the first carry strap.

## Description

### TECHNICAL FIELD

The present disclosure relates to an electronic apparatus.

### BACKGROUND ART

PTL 1 discloses an electronic device including a handle.

### Citation List

### Patent Literature

PTL 1: US9,930,795B2

### SUMMARY OF THE INVENTION

The electronic device of PTL 1 has room for improvement from the viewpoint of being stably carried.

An object of the present disclosure is to provide a stably portable electronic apparatus.

An electronic apparatus according to one aspect of the present disclosure includes:
an apparatus body including a first surface including a display and a second surface that intersects with the first surface and extends in a first direction;
a handle attached to the second surface to be rotatable about a rotation axis extending along the first direction;
a first attachment member positioned at one end in the first direction on the second surface of the apparatus body and having one end portion of the handle in the first direction attached rotatably about the rotation axis; and
a second attachment member positioned at another end in the first direction on the second surface of the apparatus body and having another end portion of the handle in the first direction attached rotatably about the rotation axis,
wherein the first attachment member includes
   a first lock portion that is located at an end portion far from the second attachment member among both end portions of the first attachment member in the first direction and is connectable to a first carry strap, and
the second attachment member includes
   a second lock portion that is located at an end portion far from the first attachment member among both end portions of the second attachment member in the first direction and is connectable to the first carry strap.

According to the present disclosure, a stably portable electronic apparatus can be realized.

### BRIEF DESCRIPTION OF THE DRAWINGS

Fig. 1 is a perspective view illustrating an electronic apparatus of one embodiment of the present disclosure.
Fig. 2 is a first enlarged plan view of the electronic apparatus of Fig. 1.
Fig. 3 is an enlarged perspective view of the electronic apparatus in Fig. 1.
Fig. 4 is a second enlarged plan view of the electronic apparatus of Fig. 1.
Fig. 5 is an enlarged perspective view of the electronic apparatus of Fig. 1 in a state where a part of a case is removed.
Fig. 6 is a first enlarged perspective view of the electronic apparatus of Fig. 1 in a state where a case is removed.
Fig. 7 is a second enlarged perspective view of the electronic apparatus of Fig. 1 in a state where a case is removed.

### DESCRIPTION OF EMBODIMENT

The present inventors have found a configuration of a stably portable electronic apparatus, and have reached the following invention.

An electronic apparatus according to a first aspect of the present disclosure includes:
an apparatus body including a first surface including a display and a second surface that intersects with the first surface and extends in a first direction;
a handle attached to the second surface to be rotatable about a rotation axis extending along the first direction;
a first attachment member positioned at one end in the first direction on the second surface of the apparatus body and having one end portion of the handle in the first direction attached rotatably about the rotation axis; and
a second attachment member positioned at another end in the first direction on the second surface of the apparatus body and having another end portion of the handle in the first direction attached rotatably about the rotation axis,
wherein the first attachment member includes
   a first lock portion that is located at an end portion far from the second attachment member among both end portions of the first attachment member in the first direction and is connectable to a first carry strap, and
the second attachment member includes
   a second lock portion that is located at an end portion far from the first attachment member among both end portions of the second attachment member in the first direction and is connectable to the first carry strap.

According to a second aspect of the present disclosure, in the electronic apparatus according to the first aspect,
the first lock portion is positioned closer to the first attachment member than a portion of the one end portion of the handle farthest from the first attachment member in the first direction.

According to a third aspect of the present disclosure,
in the electronic apparatus according to the first aspect or the second aspect,
the first attachment member includes:
   a first member fixed to the apparatus body from the first direction, a second direction intersecting the first surface, and a third direction intersecting the first direction and the second direction; and
   a second member including the first lock portion and fixed to the first member.

According to a fourth aspect of the present disclosure, in the electronic apparatus according to the third aspect,
the second member extends from the second surface to a third surface adjacent to the first surface and the second surface, and includes a first end portion positioned near the second surface in a fourth direction in which the second member extends and a second end portion positioned near the third surface in the fourth direction,
the first end portion includes a bearing that supports a shaft defining the rotation axis, and
the second end portion includes the first lock portion and a fix portion that fixes the second member to the first member.

According to a fifth aspect of the present disclosure, in the electronic apparatus according to the fourth aspect,
the first attachment member includes
   a stopper positioned between the first end portion and the second end portion of the second member, fixed to the first member, and regulating a rotation range of the handle by coming into contact with one end portion of the handle,
the second member is positioned between the stopper and the first member, and the stopper is fixed to the first member via the second member.

According to a sixth aspect of the present disclosure,
in the electronic apparatus according to the third to fifth aspects,
the first attachment member includes
   a third lock portion that is located at one end portion of both ends of the first member in the second direction far from the first surface and that is connectable to a second carrying strap.

Hereinafter, an embodiment of the present disclosure will be described with reference to the drawings. The following description is not intended to limit the present disclosure, but is merely exemplary in nature, and can be appropriately changed without departing from the gist of the present disclosure. Moreover, the drawings are schematic representations, and the ratios between dimensions or the like do not necessarily match the actual dimensions.

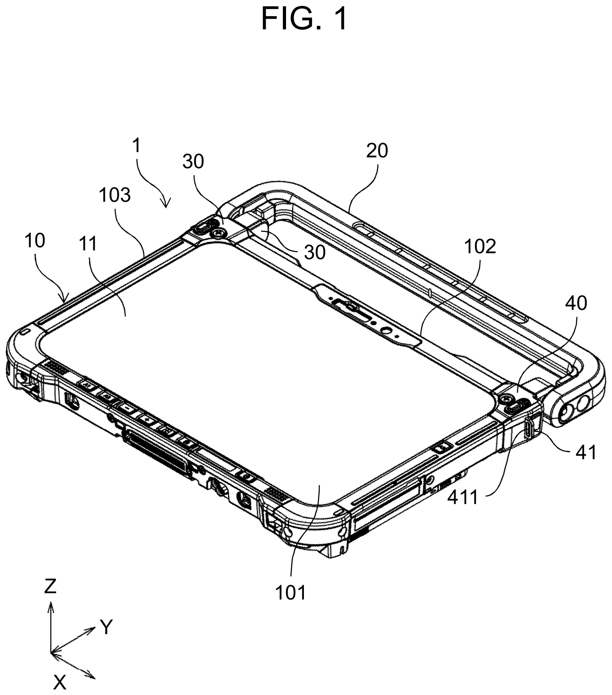

As illustrated in Fig. 1, electronic apparatus 1 according to an embodiment of the present disclosure includes apparatus body 10, handle 20, and first attachment member 30 and second attachment member 40 for attaching handle 20 to apparatus body 10.

As illustrated in Fig. 1, apparatus body 10 has a substantially rectangular plate shape, and includes first surface 101 on which display 11 is disposed, second surface 102 that intersects with first surface 101 and extends in the first direction (for example, in X direction), and third surface 103 that intersects with and is adjacent to first surface 101 and second surface 102. Handle 20 is attached rotatably to second surface 102 via first attachment member 30 and second attachment member 40.

Apparatus body 10 is, for example, a tablet computer. Display 11 includes, for example, a touch panel type liquid crystal display capable of accepting a touch operation by a user.

Apparatus body 10 includes a processor, a storage, and a communication unit. The processor includes a CPU, an MPU, a GPU, a DSP, an FPGA, an ASIC, and the like. The storage includes, for example, an internal recording medium or an external recording medium. The internal recording medium includes a nonvolatile memory and the like. The external recording medium includes a hard disk (HDD), a solid state drive (SSD), an optical disk device, and the like. The communication unit includes, for example, a communication circuit or a communication module for transmitting and receiving data relative to an external device such as a server. The storage stores an operating system (OS), various application programs, various data, and the like. The processor implements various functions by reading an OS, application programs, and various data and executing arithmetic processing.

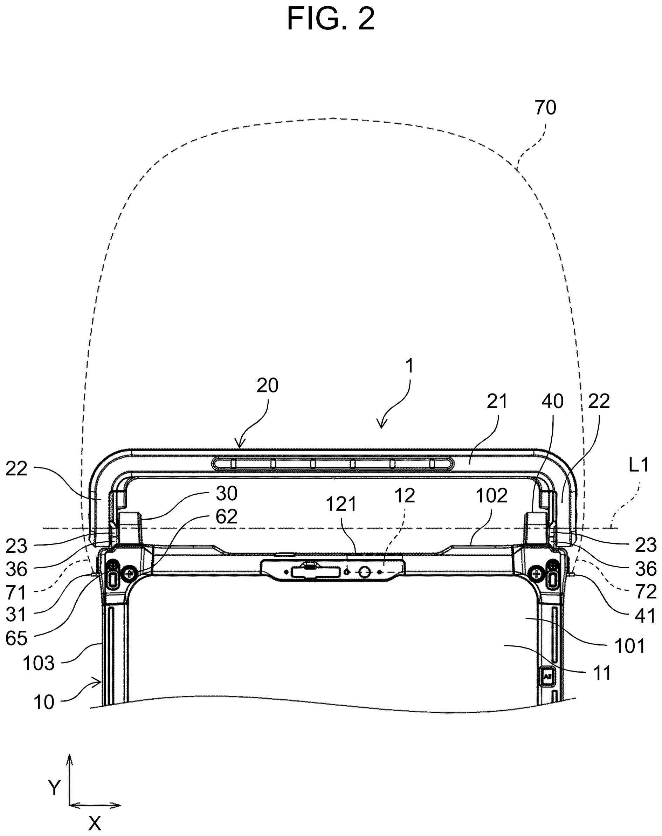

As illustrated in Fig. 2, apparatus body 10 includes barcode reader 12. Barcode reader 12 includes sensor 121 capable of reading a barcode. Sensor 121 is located substantially at the center of second surface 102 in first direction X. For example, barcode reader 12 is used by rotating handle 20 so as not to be positioned in a reading direction (for example, in Y direction,) of sensor 121.

As illustrated in Fig. 2, handle 20 is attached to second surface 102 of apparatus body 10, and is rotatable about rotation axis L1 extending along first direction X. In the present embodiment, handle 20 has a substantially C-shape and includes grip 21 having a rod-like shape extending along second surface 102 and connection portion 22 extending from each of both ends of grip 21 toward apparatus body 10.

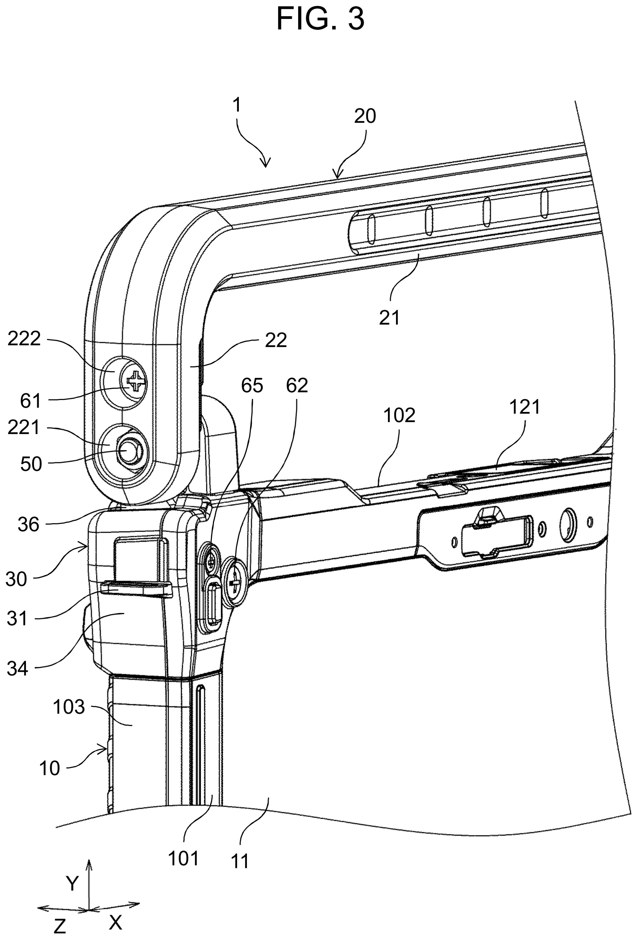

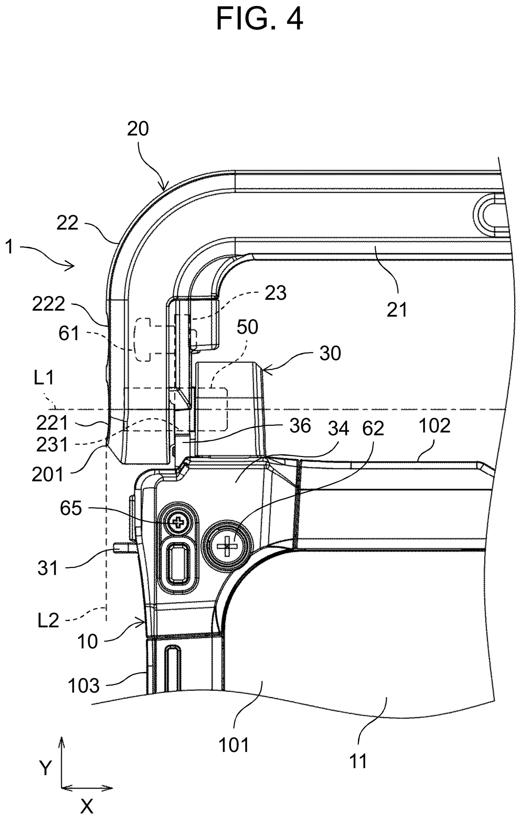

As illustrated in Fig. 3, connection portion 22 has through hole 221 in which shaft 50 defining rotation axis L1 is accommodated and fastening hole 222 in which fastening member 61 such as a screw is accommodated. As illustrated in Fig. 4, shaft 50 extends to first attachment member 30 or second attachment member 40. In Figs. 3 and 4, only first attachment member 30 side is shown.

Handle bracket 23 is located between connection portion 22 and first attachment member 30 or second attachment member 40 in first direction X. Handle bracket 23 has a substantially rectangular plate shape extending in a direction intersecting rotation axis L1 (for example, in Y direction), and fastening member 61 is fixed to one end in the longitudinal direction thereof. Through hole 231 in which shaft 50 is rotatably accommodated is formed at the other end in the longitudinal direction of handle bracket 23. In the present embodiment, since handle 20 is fixed to handle bracket 23 by fastening member 61, handle 20 can be more reliably attached to first attachment member 30 or second attachment member 40.

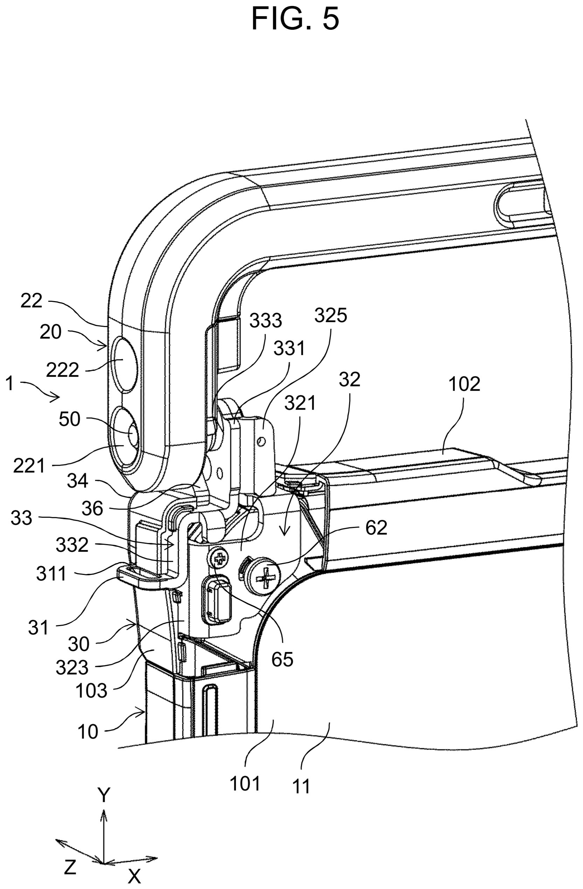

As illustrated in Fig. 2, first attachment member 30 is positioned at one end of second surface 102 of apparatus body 10 in first direction X. First attachment member 30 may be mountable in a state where one end portion of handle 20 in first direction X, that is, one connection portion 22 is rotatable around rotation axis L1. First attachment member 30 has first lock portion 31 that is connectable to first carry strap 70. First carry strap 70 is, for example, a string-like shoulder strap for carrying electronic apparatus 1 over a shoulder, and a connection member such as a swivel hook is located at one end 71 and other end 72 in the longitudinal direction. First lock portion 31 has a substantially rectangular plate shape extending along a second direction (for example, in Z direction) intersecting first surface 101 of apparatus body 10, and has through hole 311 (see Fig. 5) that is connectable to a connection member of first carry strap 70.

In the present embodiment, as shown in Fig. 4, first lock portion 31 is positioned closer to first attachment member 30 than portion 201 farthest from first attachment member 30 in first direction X at one end portion of handle 20. A gap is formed between first lock portion 31 and imaginary straight line L2 that passes through portion 201 positioned outermost in first direction X of handle 20 and is orthogonal to rotation axis L1.

As illustrated in Fig. 2, second attachment member 40 is positioned at the other end of second surface 102 of apparatus body 10 in first direction X. Second attachment member 40 may be mountable in a state where the other end portion of handle 20 in first direction X, that is, other connection portion 22 is rotatable around rotation axis L1. Second attachment member 40 has second lock portion 41 that is connectable to first carry strap 70. Second lock portion 41 has a substantially rectangular plate shape extending along a second direction (for example, in Z direction) intersecting first surface 101 of apparatus body 10, and has through hole 411 (see Fig. 1) that is connectable to a connection member of first carry strap 70.

In the present embodiment, first lock portion 31 and second lock portion 41 have the same shape and configuration. Similarly to first lock portion 31, second lock portion 41 is also positioned closer to second attachment member 40 than a portion farthest from second attachment member 40 in first direction X at the other end portion of handle 20.

First attachment member 30 of the present embodiment will be described in more detail with reference to Figs. 5 to 7. In the present embodiment, first attachment member 30 and second attachment member 40 have the same configuration. Therefore, description of second attachment member 40 is omitted.

As illustrated in Fig. 5, first attachment member 30 includes first member 32 fixed to apparatus body 10 and second member 33 fixed to first member 32. Second member 33 includes first lock portion 31. First attachment member 30 includes case 34 that accommodates first member 32 and second member 33 therein, and is located at a corner of apparatus body 10.

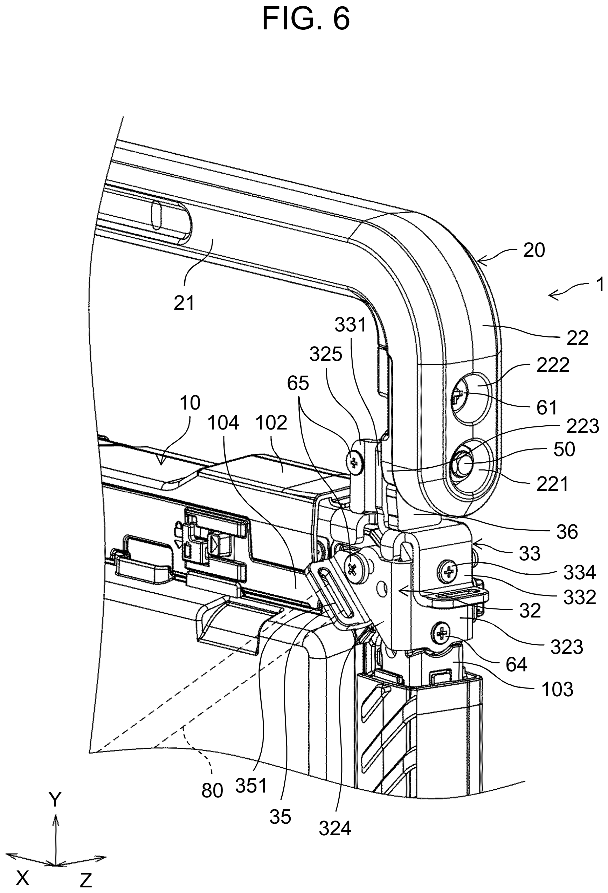

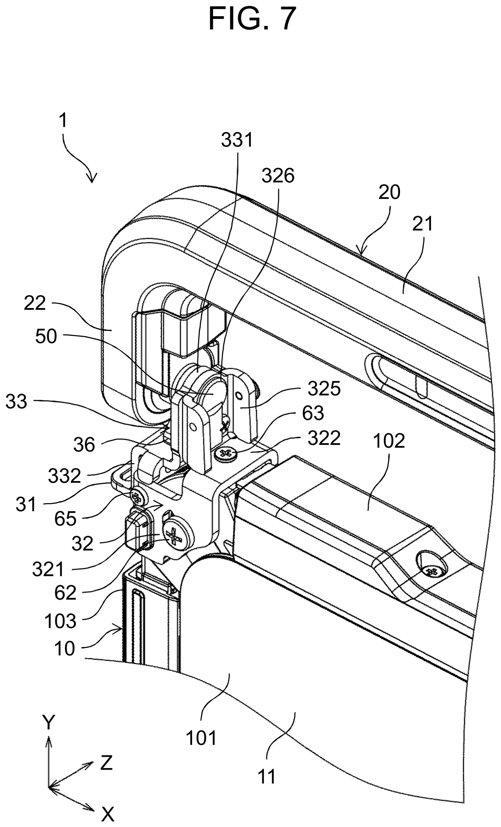

For example, as illustrated in Figs. 5 to 7, first member 32 is formed of one plate-like member, and covers first surface 101, second surface 102, third surface 103, and fourth surface 104 positioned on the opposite side of first surface 101 of apparatus body 10. As illustrated in Fig. 5, portion 321 of first member 32 facing first surface 101 is fixed to first surface 101 of apparatus body 10 by fastening member 62. As illustrated in Fig. 7, portion 322 of first member 32 facing second surface 102 is fixed to second surface 102 of apparatus body 10 by fastening member 63. As illustrated in Fig. 6, portion 323 of first member 32 facing third surface 103 is fixed to third surface 103 of apparatus body 10 by fastening member 64. That is, first member 32 is fixed to apparatus body 10 from first direction X, second direction Z, and third direction Y.

Support portion 325 extending along connection portion 22 of handle 20 is located in portion 322 facing second surface 102 of first member 32. Support portion 325 is positioned inside connection portion 22 (in other words, between the pair of connection portions 22) and is adjacent to connection portion 22. Bearing 326 that rotatably supports shaft 50 is located at an end portion of support portion 325 far from apparatus body 10 in third direction Y.

As shown in Fig. 6, first attachment member 30 includes third lock portion 35 that is connectable to second carry strap 80. Third lock portion 35 is located at an end portion farther from first surface 101, in other words, at portion 324 facing fourth surface 104 of first member 32, of both ends of first member 32 in second direction Z. that is connectable to third lock portion 35 has, for example, a substantially rectangular plate shape extending from second surface 102 toward third surface 103, and has through hole 351 that is connectable to a member such as a swivel hook provided on second carry strap 80. Second carry strap 80 is, for example, a hand strap to be wound around and carried by a hand holding electronic apparatus 1.

Case 34 is fixed to portion 321 facing first surface 101 and portion 324 facing fourth surface 104 of first member 32 by fastening member 65.

As illustrated in Fig. 5, second member 33 extends from second surface 102 to third surface 103 of apparatus body 10. In the present embodiment, second member 33 is formed of one plate-like member different from first member 32. Second member 33 has a substantially W-shaped plate shape, and has first end portion 331 positioned near second surface 102 in the direction in which second member 33 extends and second end portion 332 positioned near third surface 103 in the direction in which second member 33 extends.

First end portion 331 is positioned closer to connection portion 22 of handle 20 than support portion 325 of first member 32 in first direction X, and extends along support portion 325. Bearing 333 that supports shaft 50 is located at a position corresponding to bearing 326 of support portion 325 in first end portion 331.

Second end portion 332 extends along third surface 103 of apparatus body 10. First lock portion 31 is located at a distal end of second end portion 332. Fix portion 334 (shown in Fig. 6) for fixing second member 33 to first member 32 is located in a portion of second end portion 332 closer to first end portion 331 than first lock portion 31. In the present embodiment, fix portion 334 is formed of a fastening member, and fixes second end portion 332 to third surface 103.

First attachment member 30 includes stopper 36 that comes into contact with one end portion (that is, connection portion 22) of handle 20 and can regulate the rotation range of handle 20. In the present embodiment, as illustrated in Fig. 6, stopper 36 may contact portion 223 located on a surface of connection portion 22 facing support portion 325. Stopper 36 is positioned between first end portion 331 and second end portion 332 of second member 33, and is fixed to second member 33. First end portion 331 of second member 33 is positioned between stopper 36 and support portion 325 of first member 32, and stopper 36 is fixed to first member 32 via first end portion 331.

### Electronic apparatus 1 can exhibit the following effects.

Electronic apparatus 1 includes apparatus body 10, handle 20, first attachment member 30, and second attachment member 40. Apparatus body 10 includes first surface 101 on which display 11 is disposed and second surface 102 that intersects with first surface 101 and extends in the first direction. Handle 20 is attached to second surface 102 and is rotatable about rotation axis L1. First attachment member 30 is located at one end of second surface 102 of apparatus body 10 in the first direction, and one end portion of handle 20 in the first direction is rotatably mounted around rotation axis L1. Second attachment member 40 is positioned at the other end of second surface 102 of apparatus body 10 in the first direction, and the other end portion of handle 20 in the first direction is rotatably attached around rotation axis L1. First attachment member 30 is located at an end portion farther from second attachment member 40 among both end portions of first attachment member 30 in the first direction, and has first lock portion 31 that is connectable to first carry strap 70. Second attachment member 40 is located at an end portion farther from first attachment member 30 among both end portions in the first direction of second attachment member 40, and has second lock portion 41 that is connectable to first carry strap 70. With such a configuration, it is possible to realize electronic apparatus 1 that can be stably carried by first carry strap 70. In addition, first lock portion 31 is located at an end portion farther from second attachment member 40 among both end portions in the first direction of first attachment member 30, and second lock portion 41 is located at an end portion farther from first attachment member 30 among both end portions in the first direction of second attachment member 40. Therefore, it is possible to prevent carry strap 70 which is hanging from partially blocking the display 11.

First lock portion 31 is positioned closer to first attachment member 30 than portion 201 farthest from first attachment member 30 in the first direction at one end portion of handle 20. With such a configuration, it is possible to prevent first lock portion 31 from coming into contact with the floor or the like before handle 20.

First attachment member 30 includes first member 32 fixed to apparatus body 10 from the first direction, the second direction, and the third direction, and second member 33 including first lock portion 31 and fixed to first member 32. With such a configuration, first attachment member 30 can be more reliably fixed to apparatus body 10.

Second member 33 extends from second surface 102 to third surface 103, and has first end portion 331 positioned near second surface 102 in the direction in which second member 33 extends and second end portion 332 positioned near third surface 103 in the direction in which second member 33 extends. First end portion 331 includes bearing 333 that supports shaft 50 defining rotation axis L1, and second end portion 332 includes first lock portion 31 and fix portion 334 that fixes second member 33 to first member 32. With such a configuration, second member 33 can be more reliably fixed to first member 32.

First attachment member 30 is positioned between first end portion 331 and second end portion 332 of second member 33 and fixed to first member 32, and includes stopper 36 that comes into contact with one end portion of handle 20 to regulate rotation range of handle 20. Second member 33 is positioned between stopper 36 and first member 32, and stopper 36 is fixed to first member 32 via second member 33. With such a configuration, it is possible to reliably fix stopper 36 to first member 32 while restricting the rotation range of handle 20.

First attachment member 30 is located at one of both ends of first member 32 in the second direction far from first surface 101, and has third lock portion 35 that is connectable to second carry strap 80. With such a configuration, for example, since the hand strap can be attached to electronic apparatus 1 in addition to the shoulder strap, it is possible to realize electronic apparatus 1 that can be carried more stably.

Electronic apparatus 1 can also be configured as follows.

First attachment member 30 may be positioned at one end of second surface 102 of apparatus body 10 in first direction X. For example, first attachment member 30 may be attached only to second surface 102, or may be attached from second surface 102 to another surface (for example, third surface 103) of apparatus body 10. Similarly, second attachment member 40 may be positioned at the other end of second surface 102 of apparatus body 10 in first direction X. For example, second attachment member 40 may be attached only to second surface 102, or may be attached from second surface 102 to another surface of apparatus body 10.

First lock portion 31 is not necessarily positioned closer to first attachment member 30 than portion 201 farthest from first attachment member 30 in first direction X at one end portion of handle 20. First lock portion 31 may be positioned at the same position as portion 201 of handle 20 in first direction X, or may be positioned farther from first attachment member 30 than portion 201 of handle 20.

Each of first lock portion 31, second lock portion 41, and third lock portion 35 may be connectable with only one type of carry strap, or may be connectable with a plurality of types of carry straps. For example, first lock portion 31 and second lock portion 41 may connect only first carry strap 70, or may connect another carry strap including second carry strap 80 in addition to first carry strap 70.

First carry strap 70 is not limited to the shoulder strap, and may be another carry strap including a hand strap. Similarly, second carry strap 80 is not limited to the hand strap, and may be another carry strap including a shoulder strap.

First attachment member 30 is not limited to the attachment member having first member 32 and second member 33, and any configuration having first lock portion 31 can be adopted. Similarly, second attachment member 40 can adopt any configuration having second lock portion 41.

First attachment member 30 and second attachment member 40 are not limited to have the same configuration, and may have different configurations.

The shapes and configurations of first member 32 and second member 33 can be arbitrarily changed according to the design of electronic apparatus 1 or the like.

Third lock portion 35 and stopper 36 can be omitted.

By appropriately combining discretionary embodiments or modifications among the various embodiments or modifications, it is possible to achieve the respective effects. A combination of embodiments, a combination of examples, or a combination of embodiments and examples is possible, and a combination of features in different embodiments or examples is also possible.

Although the present disclosure has been described in connection with a preferable embodiment with reference to the accompanying drawings, various modifications and corrections are obvious to those skilled in the art. Such variations and modifications are to be understood as being included within the scope of the present disclosure as set forth in the appended scope of claims unless departing from the scope of the present disclosure.

### INDUSTRIAL APPLICABILITY

The present disclosure is widely applicable to electronic apparatuses including tablet computers.

### REFERENCE MARKS IN THE DRAWINGS

1: electronic apparatus
10: apparatus body
101: first surface
102: second surface
103: third surface
104: fourth surface
11: display
12: barcode reader
121: sensor
20: handle
21: grip
22: connection portion
221: through hole
222: fastening hole
223: contact portion
23: handle bracket
231: through hole
30: first attachment member
31: first lock portion
311: through hole
32: first member
321: portion facing first surface
322: portion facing second surface
323: portion facing third surface
324: portion facing fourth surface
325: support portion
326: bearing
33: second member
331: first end portion
332: second end portion
333: bearing
334: fix portion
34: case
35: third lock portion
36: stopper
40: second attachment member
41: second lock portion
50: shaft
61, 62, 63, 64, 65: fastening member
70, 80: carry strap
L1: rotation axis

## Claims

1. An electronic apparatus comprising:
an apparatus body including a first surface including a display and a second surface that intersects with the first surface and extends in a first direction;
a handle attached to the second surface to be rotatable about a rotation axis extending along the first direction;
a first attachment member positioned at one end in the first direction on the second surface of the apparatus body and having one end portion of the handle in the first direction attached rotatably about the rotation axis; and
a second attachment member positioned at another end in the first direction on the second surface of the apparatus body and having another end portion of the handle in the first direction attached rotatably about the rotation axis,
wherein the first attachment member includes
a first lock portion that is located at an end portion far from the second attachment member among both end portions of the first attachment member in the first direction and is connectable to a first carry strap, and
the second attachment member includes
a second lock portion that is located at an end portion far from the first attachment member among both end portions of the second attachment member in the first direction and is connectable to the first carry strap.

2. The electronic apparatus according to Claim 1, wherein the first lock portion is positioned closer to the first attachment member than a portion of the one end portion of the handle farthest from the first attachment member in the first direction.

3. The electronic apparatus according to Claim 1 or 2, wherein
the first attachment member includes:
a first member fixed to the apparatus body from the first direction, a second direction intersecting the first surface, and a third direction intersecting the first direction and the second direction; and
a second member including the first lock portion and fixed to the first member.

4. The electronic apparatus according to Claim 3, wherein the second member extends from the second surface to a third surface adjacent to the first surface and the second surface, and includes a first end portion positioned near the second surface in a fourth direction in which the second member extends and a second end portion positioned near the third surface in the fourth direction,
the first end portion includes a bearing that supports a shaft defining the rotation axis, and
the second end portion includes the first lock portion and a fix portion that fixes the second member to the first member.

5. The electronic apparatus according to Claim 4, wherein
the first attachment member includes a stopper positioned between the first end portion and the second end portion of the second member, fixed to the first member, and regulating a rotation range of the handle by coming into contact with one end portion of the handle, and
the second member is positioned between the stopper and the first member, and the stopper is fixed to the first member via the second member.

6. The electronic apparatus according to Claim 3, wherein the first attachment member includes a third lock portion that is located at one end portion of both ends of the first member in the second direction far from the first surface and that is connectable to a second carrying strap.
